# EUROPEAN PATENT APPLICATION

(11) **EP 3 933 938 A1**
(43) Date of publication of application: **05.01.2022**
(21) Application number: 20719113.1
(22) Date of filing: 24.02.2020
(51) Int. Cl.: H01L 31/054, H01L 31/0232, H01L 31/042, H01L 31/02, H02S 20/30, H02S 40/22, H02S 30/20, H02S 30/10, H02S 20/20, H01L 31/05

(54) **SOLAR CELL MODULE**

(30) Priority: 27.02.2019 KR 20190022944; 10.07.2019 KR 20190082926; 12.12.2019 KR 20190165721; 20.01.2020 KR 20200007527
(71) Applicant: Nanovalley Co., Ltd., Yuseong-gu Daejeon 34056 (KR)
(72) Inventor: JUN, Young-kwon, Pohang-si Gyeongsangbuk-do 37673 (KR)
(74) Representative: Beck & Rössig European Patent Attorneys
(86) International application number: PCT/KR2020/002592
(87) International publication number: WO 2020/175864

(57) **Abstract**

The present invention relates to a structure of a photovoltaic cell module capable of improving a power generation output by increasing a light receiving area and a sunshine duration. The photovoltaic cell module includes a crystalline photovoltaic cell such as single crystalline silicon, polycrystalline silicon, or gallium arsenic (GaAs) and a CdTe, CIGS/CIS, or a fuel sensitive thin-film photovoltaic cell.

The photovoltaic cell module according to the present invention includes a support unit and a plurality of photovoltaic cell unit module installed on the support unit and has a protruding shape curved with a predetermined shape toward a surface.

## Description

### TECHNICAL FIELD

The present invention relates to a photovoltaic cell module capable of improving a power generation output per a unit area in which the photovoltaic cell module is installed in comparison with a typical photovoltaic cell module. The photovoltaic cell module includes a crystalline photovoltaic cell such as single crystalline silicon, polycrystalline silicon, and gallium arsenic (GaAs) and a CdTe, CIGS/CIS, and fuel sensitive thin-film photovoltaic cell.

### BACKGROUND ART

A crystalline and thin-film photovoltaic cell technology is a clean energy source capable of replacing a typical electrical energy source. Although continuously distributed, this technology has a limitation in commercialization due to a high power generation unit cost in comparison with a typical method such as a coal fired power generation and a nuclear power generation. Among these, the thin-film photovoltaic cell is a next generation photovoltaic cell technology compared with the crystalline silicon photovoltaic cell occupying currently biggest market share. Various kinds of thin-film photovoltaic cells have been developed, and a representative example is a CIGS(Cu(In,Ga)Se2) or CIS(CuInSe2) photovoltaic cell. The CIGS/CIS photovoltaic cell is a cell in which a light absorbing layer for absorbing the sunlight is made of CIGS or CIS in a general cell having a laminated structure of glass substrate/ground electrode/light absorbing layer/buffer layer/front transparent electrode. CIGS is more widely used for the light absorbing layer. CIGS is a I-III-VI group chalcopyrite compound semiconductor. CIGS is a material having a direct transition type energy band gap and a relatively high light absorbing coefficient of about 1×105cm⁻¹ among semiconductors. CIGS is a material capable of manufacturing a high efficiency photovoltaic cell even with a thickness of 1 µm to 2 µm. However, the crystalline and thin-film photovoltaic cell also exhibits a power generation efficiency less than 30%. Thus, in order to increase a power generation amount, more installation areas are required, and thus installation costs increase.

On the other hand, a current used photovoltaic cell module is installed in an array type by fixing and connecting a plurality of unit panels each having a plate shape.

In relation to the array structure, Korean Laid-open Utility Model No. 2018-0002627 discloses a structure convenient for a user to carry and store by installing a flat photovoltaic cell on a bamboo piece type plate or substrate and rolling the photovoltaic cell for accommodation. Since this structure is configured by serially connecting neighboring two photovoltaic cells by using a copper strip or a rod, repeated usage and storage may generate bending and folding to cause a damage on a connected portion such as a wire.

Also, Korean Laid-open Utility Model No. 2017-0003830 discloses a method for protecting a photovoltaic cell module from external impact or wind pressure such that one pair of two photovoltaic cell modules forms a folding-type structure, the two modules are connected by a hinge, and when this is folded, one module is folded on the other module to expose a rear surface of the upper module to incident light. However, since the folding-type module includes only two modules, and neighboring photovoltaic cell modules are connected by a round rug serving as a '⊏'-shaped bolt, this structure may be used only in a flat-type.

Also, in case of a photovoltaic cell module manufactured by serial and/or parallel-connecting a plurality of unit cells to be arranged in a large area flat type, a great output may not be produced in a narrow space, reflected light, which is reflected by each unit module, may not be re-absorbed, and transferring and storing may be inconvenient. To resolve the above-described limitations, Korean Registered Patent No. 10-1730562 discloses a structure for easily assembling and disassembling unit modules of a photovoltaic cell module, but does not disclose a structure of increasing a power generation efficiency in the same installation area and re-absorbing reflected light.

### DISCLOSURE OF THE INVENTION

### TECHNICAL PROBLEM

The present invention provides a photovoltaic cell module capable of performing an effective and economical photovoltaic cell power generation by increasing a power generation amount per an installation area and/or a photovoltaic cell panel in comparison with a typical flat module.

The present invention also provides a photovoltaic cell module capable of being disassembled into a module unit (or a unit module) so that the photovoltaic cell module is folded for transfer and storage.

### TECHNICAL SOLUTION

The present invention provides a plurality of embodiments as stated below to resolve the above technical limitations.

A first embodiment of the present invention provides a photovoltaic cell module including at least two unit modules. Here, each of the unit modules includes at least one photovoltaic cell including a light absorbing layer and an electrode, and a power generation is performed in a state in which an own shape of the unit module or an arranged shape of two or more unit modules forms an uneven portion on an incident surface to which the sunlight is incident.

In the first embodiment, the photovoltaic cell module may further include a support unit on which the unit module is installed. Here, the support unit may include at least one post fixed to the ground or a structure, a support fixed to the post, and a holder configured to form an uneven shape on the support, the unit module may include a plate shape, and at least two unit modules may be installed on the holder to form an uneven portion on an incident surface to which the sunlight is incident.

In the first embodiment, each of the at least two unit modules may have a rectangular shape in which a length in one direction is greater by two times than a length in the other direction.

In the first embodiment, the holder may have a shape of a rod extending in a longitudinal direction, and the rod may have a cross-section having a polygonal shape, a semi-circular shape, or a semi-elliptical shape.

In the first embodiment, the unit module may include a flexible photovoltaic cell, and the flexible photovoltaic cell may be molded to form an uneven portion on an incident surface to which the sunlight is incident.

In the first embodiment, the unit modules may be arranged with different orientations to be adjusted in height and direction.

In the first embodiment, the unit module may include at least two kinds having different protruding shapes and/or different heights.

In the first embodiment, the support unit may have a curved shape having a predetermined radius, and the at least two unit modules may form a shape protruding to be curved with a predetermined shape toward a surface on the support unit, and the uneven shape may overlap the curved shape of the support unit.

In the first embodiment, the unit module may be installed to form an uneven portion including an embossing shape on the support unit.

In the first embodiment, the unit module may include a plurality of uneven portions including an embossing shape.

A second embodiment of the present invention provides a photovoltaic cell module including at least two unit modules. Here, each of the unit modules includes at least one photovoltaic cell including a light absorbing layer and an electrode, a connection unit configured to connect the at least two unit modules is disposed between the at least two unit modules, the connection unit allows the unit modules to be folded and simultaneously adjusts and fixes a folded angle, and a power generation is performed in a state in which the at least two unit modules face each other at a predetermined angle by the connection unit to form an uneven portion on an incident surface to which the sunlight is incident.

In the second embodiment, a facing angle of the unit modules may be in a range from 30° to 330°, and a gap between the unit modules may be equal to or less than a width of the unit module.

In the second embodiment, the connection unit may include a shaft, a connection member rotatably connected to the shaft, and a fixing connector coupled with one side of the connection member configured to connect neighboring unit modules to adjust and fix a folded angle between the unit modules, and as one side or both sides of each of the unit modules is or are connected to the connection member, the unit module may be rotatably connected to the shaft.

In the second embodiment, the fixing connector may include a body, a first fixing member connected to the body and fixed to one end of the unit module, and a second fixing member fixed to one end of the unit module adjacent and connected to the unit module fixed to the first fixing member, and the folded angle between the unit modules may be adjusted by adjusting an angle between the first fixing member and the second fixing member.

In the second embodiment, the fixing connector may include a body, a first fixing member connected to the body and fixed to one end of the unit module, and a second fixing member fixed to one end of the unit module adjacent and connected to the unit module fixed to the first fixing member, one side or both sides of each of the first fixing member and the second fixing member may be rotatably connected to the body, and as an angle adjusting unit configured to fix the first fixing member or the second fixing member, which is rotatably connected, is provided, an angle between the first fixing member or the second fixing member may be adjusted through the first fixing member, the second fixing member, and the angle adjusting unit.

In the second embodiment, the fixing connector may include a driving unit, a first fixing member fixed to one end of the unit module, and a second fixing member fixed to one end of the unit module adjacent and connected to the unit module fixed to the first fixing member, and the driving unit may rotate one side or both sides of each of the first fixing member and the second fixing member to adjust an angle between the first fixing member and the second fixing member.

In the second embodiment, the photovoltaic cell module may further include: a support configured to support at least one of the at least two unit modules; and a fixing unit configured to fix the unit module on the support.

In the second embodiment, the at least two unit modules may be separated from or coupled to each other.

A third embodiment of the present invention provides a photovoltaic cell module including at least two unit modules. Here, each of the unit modules includes at least one photovoltaic cell including a light absorbing layer and an electrode, and a power generation is performed in a state an uneven portion is formed on an incident surface to which the sunlight is incident by including: a unit module connection unit configured to connect the at least two unit modules with neighboring unit module in a bendable manner; and a unit module spacing unit coupled to the unit module and configured to adjust and fix a bent angle and a distance between the plurality of unit modules when the unit modules are bent.

In the third embodiment, the photovoltaic cell module may further include a holding unit configured to hold the unit module spacing unit.

In the third embodiment, the spacing unit may include: a plurality of support bars spaced a predetermined distance from each other; at least one spacing member configured to adjust a gap between the plurality of support bars; and at least one fixing member configured to maintain the gap adjusted by the at least one spacing member, and the unit module may be coupled to the plurality of support bars in a bendable manner.

In the third embodiment, the holding unit may include: a lower support disposed at a lower portion; at least two inclined supports rotatably connected to adjust an inclination with respect to the lower support and spaced a predetermined distance from each other; an upper support configured to connect the at least two inclined supports to each other; and an inclined angle adjusting unit configured to adjust an inclined angle by connecting the lower support and the inclined support.

In the third embodiment, the unit module may be connected to the spacing unit by an elastic band, a Velcro, or tongs.

In the third embodiment, a bent angle between the unit module and neighboring unit module may be in a range from 0° to 360°, and a gap between the unit modules may be equal to or less than two times of a width of the unit module.

In the third embodiment, the unit module may include a single cell or a plurality of cells that are serial or parallel-connected to each other.

In the third embodiment, the spacing member may be a spring, and the fixing member may be a clamp disposed at each of both ends of the spring.

In the third embodiment, a length of the inclined support may be adjustable.

In the third embodiment, the unit module spacing unit may include: a plurality of support plates; and a connection unit configured to connect the plurality of support plates in a rotatable manner so that the plurality of support plates are folded with each other, and the plurality of photovoltaic cell unit modules may be attached to the plurality of support plates, respectively.

In the third embodiment, the unit module connection unit may include a mechanical rotating unit configured to connect the plurality of photovoltaic cell unit module in a mechanically bendable manner or a member having a flexibility to be bent by a material property without a separate mechanical unit.

A fourth embodiment of the present invention provides a photovoltaic cell module including at least two unit modules. Here, each of the unit modules includes at least one photovoltaic cell including a light absorbing layer and an electrode, and a power generation is performed in a state in which the at least two unit modules are arranged to form uneven portions facing each other on an incident surface to which the sunlight is incident.

In the fourth embodiment, the neighboring unit modules may be arranged to have a V-shape, a W-shape, or a repeated shape thereof.

In the fourth embodiment, the neighboring unit modules may be arranged to have a U-shape or a repeated shape thereof with respect to incident light.

In the fourth embodiment, an internal angle between the neighboring unit modules may be in a range from 120° to 40°.

A fifth embodiment of the present invention provides a photovoltaic cell module including at least two unit modules and a reflection plate. Here, each of the unit modules includes at least one photovoltaic cell including a light absorbing layer and an electrode, and as the at least two unit modules are arranged to form uneven portions facing each other with a predetermined angle on an incident surface to which the sunlight is incident, and the reflection plate is connected to at least a portion of an end of the photovoltaic cell panel and extends a predetermined length, a power generation is performed in a state in which the uneven portions are formed on the incident surface to which the sunlight is incident.

In the fifth embodiment, the predetermined angle may be adjustable in a range greater than 0° and less than 180°.

In the fifth embodiment, a surface of the reflection plate may extend without a stepped portion with a surface of the photovoltaic cell panel.

In the fifth embodiment, the reflection plate may extend from all of opened ends of the photovoltaic cell panel.

In the fifth embodiment, a photovoltaic cell module may include unit modules and reflection plates. Here, each of the unit modules may include at least one photovoltaic cell including a light absorbing layer and an electrode, the reflection plates may include a first reflection plate connected to one end of the unit module and inclined at a predetermined angle with respect to an incident surface of the sunlight of the unit module and a second reflection plate connected to the other end, which is disposed at a side facing the one end, of the unit module and inclined at a predetermined angle with respect to an incident surface of the sunlight of the photovoltaic cell panel, and as the first reflection plate and the second reflection plate are arranged to face each other, a power generation may be performed in a state in which an uneven portion is formed on the incident surface to which the sunlight is incident.

In the fifth embodiment, an internal angle between the first reflection plate and the second reflection plate, which face each other, may be in a range from 40° to 120°.

In the fifth embodiment, each of the first reflection plate and the second reflection plate may have a width greater by one times and equal to or less than three times of a transverse width of the photovoltaic cell panel and a length equal to or less by one times than a longitudinal length of the photovoltaic cell panel.

A sixth embodiment of the present invention provides a photovoltaic cell module including a unit module and reflection plates. Here, the unit module includes at least one photovoltaic cell including a light absorbing layer and an electrode, and as the reflection plates are inclined at a predetermined angle with respect to the unit modules to face each other, a power generation is performed in a state in which an uneven portion is formed on the incident surface to which the sunlight is incident.

In the sixth embodiment, the reflection plates may be inclined at a predetermined angle with respect to at least two unit photovoltaic cell panels.

In the sixth embodiment, the predetermined angle may be in a range from 40° to 120°.

In the fifth embodiment or the sixth embodiment, the reflection plate may have an area equal to or greater by one times than the photovoltaic cell panel.

In the fifth embodiment or the sixth embodiment, a surface of the reflection plate may include a metal mirror surface, a glass mirror surface, or a plastic mirror surface.

In the fifth embodiment or the sixth embodiment, the reflection plate may include a transparent substrate and a light reflecting material attached on the transparent substrate.

In the fifth embodiment or the sixth embodiment, a substrate of the reflection plate may include an insulating material.

In the fifth embodiment or the sixth embodiment, the reflection plate may include at least one hole through which wind passes. Also, a shape of the hole may be selected from the group consisting of a circular shape, a triangular shape, a rectangular shape, a polygonal shape, a cross shape, and an arbitrary shape.

In the fifth embodiment or the sixth embodiment, a thermoelectric element may be attached to the unit module or the reflection plate.

In the fifth embodiment or the sixth embodiment, a phase change material may be attached to the unit module or the reflection plate.

In the fifth embodiment or the sixth embodiment, the photovoltaic cell module may further include a holder configured to hold the unit module and the reflection plate and adjust a facing angle between the unit modules or between the unit module and the reflection plate.

In the embodiments, the photovoltaic cell including an electrode (or a ground electrode) and a light absorbing layer may be applied to the unit module.

### ADVANTAGEOUS EFFECTS

The photovoltaic cell module according to the present invention increases the power generation amount per unit area because the sunlight receiving area and the solar irradiation quantity increase in comparison with the typical flat module, which is inclinedly installed, although the solar irradiation quantity and the sunshine duration are the same as each other.

Also, when the unit module includes the curved part, the shadow between the unit modules may be reduced, and thus the installation gap may be also reduced. Particularly, when the unit module includes the thin-film photovoltaic cell including the uneven portion or the protruding cell by using the flexible thin-type silicon photovoltaic cell, the light receiving area may further improve.

Also, in case of the structure in which the plurality of separated unit modules are coupled to be folded through the connection unit, since the unit modules are connected in folding screen shape, the solar irradiation quantity may increase by adjusting the folded gap and direction in the left and right directions. Also, since the unit modules may be connected in the coupling method when used and disassembled to be separated and stored when accommodated or transferred, the maintenance may be easily performed.

Also, since the sunlight reflected by the reflection plate or the neighboring photovoltaic cell panel may be re-absorbed in addition to the sunlight directly incident to the panel through various arrangements between the photovoltaic cell panels and reflection plates, the effective and economical photovoltaic cell power generation may be performed.

### BRIEF DESCRIPTION OF THE DRAWINGS

FIG. 1 is a view illustrating a structure applied with a rectangular unit module as a configuration of a module including a curved part according to a first embodiment of the present invention.
FIG. 2 is a view showing a method of using a flexible photovoltaic cell as a method of obtaining a curved surface effect by using a flat support.
FIG. 3 is a view illustrating a thin-film photovoltaic cell manufactured on a flexible substrate including a plurality of uneven portions using an embossing process and a unit module including the same.
FIG. 4 is a view illustrating a thin-film photovoltaic cell manufactured on a flexible substrate including a plurality of uneven portions having a semi-circular column shape and a unit module including the same.
FIG. 5 is a schematic view for comparing effective incident angles of the sunlight in a photovoltaic cell module including a flat photovoltaic cell module and a curved protruding part that is an embodiment of the present invention.
FIG. 6 is a schematic view for comparing light receiving areas of the photovoltaic cell module including a bent or curved protruding part that is an embodiment of the present invention.
FIG. 7 is a view illustrating a structure applied with a rectangular unit module as a configuration of a coupling-type module according to a fifth embodiment of the present invention.
FIG. 8 is a view illustrating a rotating connection device connecting two unit modules according to the fifth embodiment of the present invention.
FIG. 9 is a view illustrating each fixing connector for fixing directions of neighboring unit modules according to the fifth embodiment of the present invention.
FIG. 10 is a view illustrating a fixing connector for variously adjusting a folded angle of unit modules according to a sixth embodiment of the present invention.
FIG. 11 is a view illustrating a fixing connector for adjusting a folded angle of unit modules through a motor according to a seventh embodiment of the present invention.
FIG. 12 is a view illustrating a state in which a coupling-type module is installed on a support having various curved shapes according to an eighth embodiment of the present invention.
FIG. 13 is a view illustrating a fixing device for attaching a unit module to a support.
FIG. 14 is a perspective view illustrating a photovoltaic cell module according to a ninth embodiment of the present invention.
FIG. 15 is an enlarged perspective view illustrating a unit module spacing unit of FIG. 14.
FIG. 16 is a front view and a side view illustrating a unit module holding unit of a photovoltaic cell module of FIG. 14.
FIG. 17 is a view exemplarily illustrating an installation shape of the photovoltaic cell module according to the ninth embodiment of the present invention.
FIG. 18 is a view illustrating a state in which the photovoltaic cell module according to the present invention is installed with respect to incident light.
FIG. 19 is a view illustrating a state in which unit modules connected in a bendable manner are attached to each surface of a bent case or support as a photovoltaic cell module according to a tenth embodiment of the present invention.
FIG. 20 is a schematic view illustrating a photovoltaic cell module according to an eleventh embodiment of the present invention.
FIG. 21 is a side cross-sectional view illustrating the photovoltaic cell module according to the eleventh embodiment of the present invention.
FIG. 22 is a view illustrating a process of assembling a panel and a reflection plate in the photovoltaic cell module according to the eleventh embodiment of the present invention.
FIG. 23 is a schematic view illustrating a photovoltaic cell module according to a twelfth embodiment of the present invention.
FIG. 24 is a schematic view illustrating a photovoltaic cell module according to a thirteenth embodiment of the present invention.
FIG. 25 is a side cross-sectional view illustrating the photovoltaic cell module according to the thirteenth embodiment of the present invention.
FIG. 26 is a view illustrating a process of assembling a panel and a reflection plate in the photovoltaic cell module according to the thirteenth embodiment of the present invention.
FIG. 27 is a side cross-sectional view illustrating a photovoltaic cell module according to a fourteenth embodiment of the present invention.
FIG. 28 is a side cross-sectional view illustrating a photovoltaic cell module according to a fifteenth embodiment of the present invention.
FIG. 29 is a plan view illustrating a photovoltaic cell module according to a sixteenth embodiment of the present invention.
FIG. 30 is a side view illustrating a photovoltaic cell module according to a seventeenth embodiment of the present invention.
FIG. 31 is a side view illustrating a photovoltaic cell module according to an eighteenth embodiment of the present invention.

### MODE FOR CARRYING OUT THE INVENTION

Hereinafter, the configuration and effects of embodiments of the present invention will be described with reference to the accompanying drawings.

Detailed descriptions related to well-known functions or configurations will be ruled out in order not to unnecessarily obscure subject matters of the present invention. Furthermore, when it is described that one comprises (or includes or has) some elements, it should be understood that it may comprise (or include or has) only those elements, or it may comprise (or include or have) other elements as well as those elements if there is no specific limitation.

### [Embodiment 1]

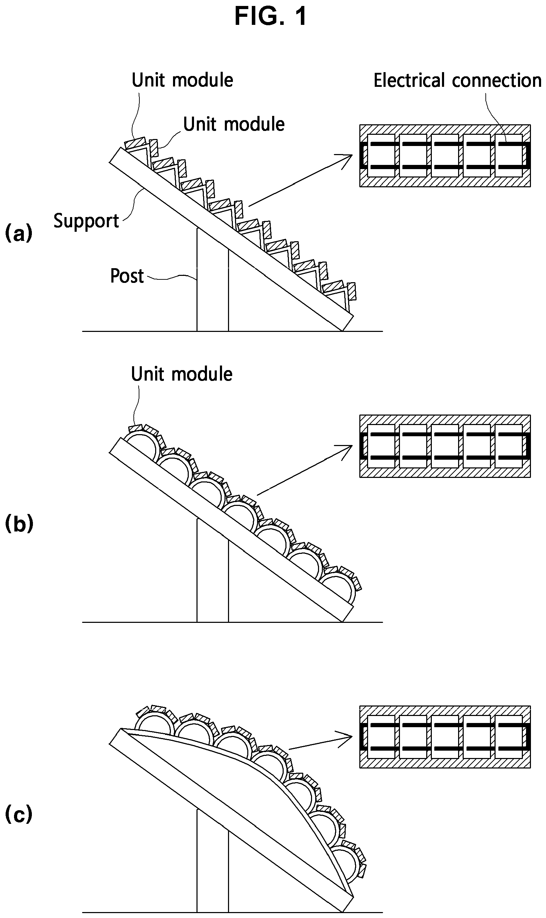

A configuration of a module according to a first embodiment of the present invention will be described through FIGS. 1A to 1C.

FIG. 1A is a view illustrating a configuration of a module in which a plurality of rectangular unit modules are installed on a support including a bent part having a triangular tube shape on an upper portion thereof.

The support including a triangular protruding part is built at an installation place such as a plain, a slope, a rooftop, outdoor facilities, or a public house. The support includes a post supported by a ground or a wall surface and a support connected to the post and including a triangular protruding part. The photovoltaic cell unit module is installed on a surface of the triangular protruding part.

As illustrated in FIG. 1A, the photovoltaic cell unit module is configured such that a plurality of photovoltaic cells are arranged in a row, and a surface electrode and a rear surface electrode of cells, which are adjacent to each other, are electrically connected to form a serial or parallel connection. The unit module is manufactured according to a typical method in such a manner that tempered glass, a photovoltaic cell, a sealing material, and a back sheet are sequentially overlapped with each other, the sealing material is pressed and heated to bond and seal each layer, and then an edge of the tempered glass is fixed and finished by a metal material such as aluminum or a plastic reinforced frame. Thus, as the plurality of photovoltaic cells are arranged in a row within a thickness of about 7mm, the light weight photovoltaic cell unit module may be realized.

On the other hand, when a half cell is applied, since an internal current is reduced, and a cell gap is narrowed to reduce a resistance loss, a power output increases, and a temperature dependent performance is enhanced. Also, since an effect such as reduction in shadow effect of the output and decrease in possibility of hot spot generation is obtained, the rectangular unit module may have a length in a major direction greater by two times or more than that in a minor direction by reflecting the effect.

FIG. 1B is a view illustrating a configuration of a module in which a plurality of rectangular photovoltaic cell unit modules are installed on a support including a plurality of curved parts such as a semicircular protruding part on an upper portion thereof.

The support includes a post supported by the ground or a wall surface and a plurality of supports connected to the post to support a plurality of curved parts. The photovoltaic cell unit module includes a plurality of unit modules coupled with the curved part to form a protruding part.

FIG. 1C is a view illustrating a configuration of a module including a curved part in which a curved part having a predetermined size and another curved part having a size less than that of the curved part having a predetermined size are alternately arranged.

That is, FIG. 1C illustrates a case when a photovoltaic cell module is configured by installing a photovoltaic cell unit module on a support including a first curved part having a predetermined curved shaped upper portion such as a convex plate and a second curved part having a curvature or a shape less in size than the convex plate.

The photovoltaic cell module in FIG. 1C may have a structure, in which a large curvature of the support overlaps a small curvature of the unit module installed on the support, to further increase a sunlit area.

Although the curved part of the support has the triangular or semicircular shape in the above embodiment, the embodiment of the present invention is not limited thereto. For example, the curved part of the support may have various shapes such as a column having a shape obtained by cutting a polygonal, circular, or oval shape in addition to the triangular or semicircular shape.

Also, the size of the curved part of the support may have a diameter of 10 cm to 10 m, a bottom side of 10 cm to 10m, and a height from the bottom side of 2 cm to 5 m. Each of the support including the curved part and a frame may be made of metal such as an aluminum alloy or stainless steel or plastic.

As described above, when the plurality of rectangular photovoltaic cell unit modules are installed to have different orientations, a generation amount may improve more than a typical flat surface installation method although the solar altitude is varied because a light receiving area and a sunshine duration increase. Also, as a weight of the unit module is reduced, management of the entire modules such as installation and maintenance may be easily performed.

### [Embodiment 2]

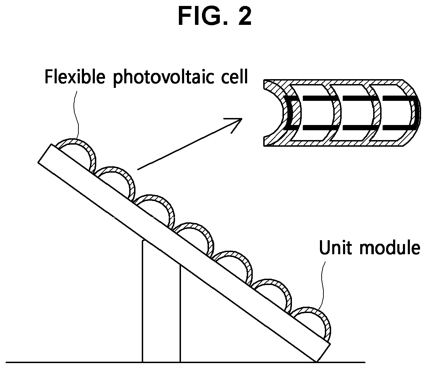

FIG. 2 is a view showing a method of using a flexible photovoltaic cell, which may obtain a curved surface effect by using a typical flat support.

The flexible photovoltaic cell includes a thin silicon photovoltaic cell and a thin-film photovoltaic cell. That is, since the typically generally used silicon photovoltaic cell has a wafer thickness of about 180 µm, the silicon photovoltaic cell is insufficient in flexibility and elasticity and thus easily broken in a bending process. However, when the thin-film silicon cell is applied, the wafer thickness may be reduced to 100 µm or less, and the flexibility and the elasticity may increase. Thus, a bending equal to or greater than 60° may be performed.

The thin-film photovoltaic cell may manufacture the flexible photovoltaic cell by using a metal substrate such as a polymer thin plate or a stainless thin plate as a substrate to easily deform a shape of the cell.

Thus, when the thin-film photovoltaic cell using the thin-film silicon photovoltaic cell or the flexible substrate is applied, the cell itself may be deformed to have a flexure. Thus, an effect of increasing a solar radiation quantity as same as that of FIG. 1 may be obtained through appropriate bending.

Here, a bending angle may be in a range from 30° to 90°, and a module substrate may be manufactured and attached to have the same bending angle.

Besides, when the thin-film photovoltaic cell is manufactured by using the flexible substrate, a plurality of minute uneven portions may be formed on the substrate to further increase a surface area.

### [Embodiment 3]

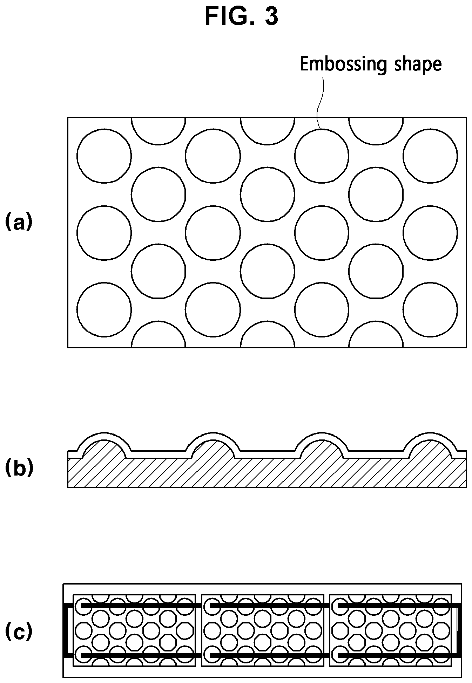

FIG. 3 is a view illustrating a thin-film photovoltaic cell manufactured on a flexible substrate including a plurality of uneven portions using an embossing process and a unit module including the same.

An embossing process method includes a method for forming a plurality of uneven portions on a substrate surface by using a device for processing an embossing on a surface of a polymer thin plate such as polyimide or a metal thin plate such as a stainless thin plate, a copper thin plate, and a zinc thin plate. The embossing process method may be generally performed in such a manner that a flexible substrate is inserted between and passes through two upper and lower embossing rolls, and an embossing or an engraving, which is formed on an outer circumferential surface of the roll, is transferred to the substrate by applying heat or pressure, to form a plurality of uneven portions. Besides, the embossing process method includes a laser patterning, a hot foil stamping, and a punch press method.

In the embossing process, the uneven portion may have a size in a range from 10 µm to 1 cm.

### [Embodiment 4]

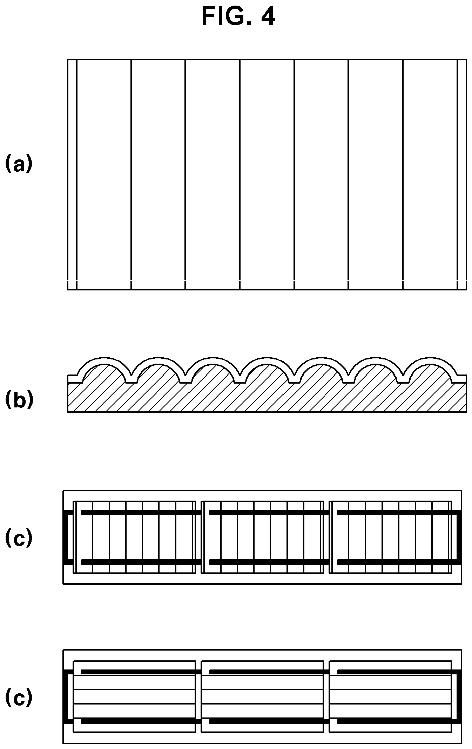

FIG. 4 is a view illustrating a thin-film photovoltaic cell manufactured on a flexible substrate including a plurality of uneven portions having a semi-circular column shape and a unit module including the same. When the cell is applied to the module, a case when a longitudinal portion of the semi-circular column is arranged in a direction perpendicular to a longitudinal portion of the rectangular module and a case when arranged in a horizontal direction are illustrated.

A method for processing the semi-circular column is the same as the method of the embodiment 3 except that the uneven portion has the semi-circular column shape.

The semi-circular column shape may have a diameter or a bottom side size in a range from 10 µm to 1 cm.

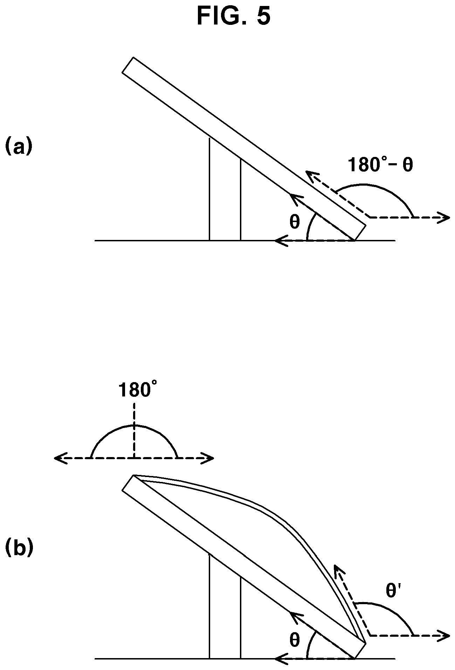

FIG. 5 shows that the flat support has an incident range from 0° to (180 - θ)° of sunlight when an installation angle θ of the support of the module to the ground is 0°<θ< 90°, and the support including the curved part has an increased incident range from 0° to 180° of sunlight although the curved part has an arbitrary curvature (90°< θ' < 180-θ°).

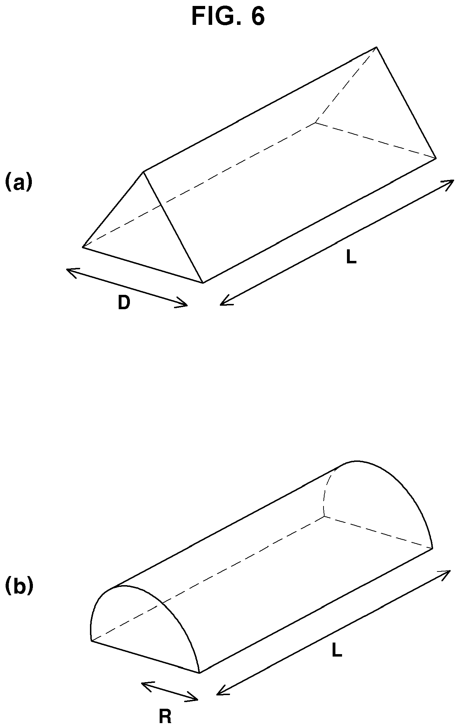

FIG. 6 illustrates that the curved part having the semi-circular column shape having a cross-sectional shape of a regular triangle has a light receiving surface area that increases by a circumferential area of the column in comparison with the flat plate. The regular triangle shape has a ratio of the circumferential area to a bottom surface of 2DL/DL, which is greater by two times, and the semi-circular shape has a ratio of the circumferential area to a bottom surface of πRL/2RL, which is greater by π/2 times.

That is, when the photovoltaic cell or the module is configured or installed to have the curved part, the solar radiation quantity or power generation quantity improves through an effect of increasing the incident angle range of sunlight and the light receiving effective area more than the typical flat module.

### [Embodiment 5]

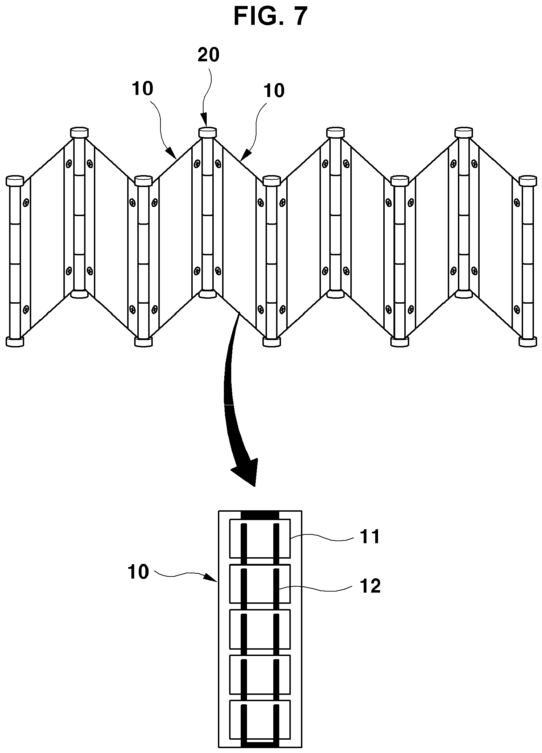

A configuration of a photovoltaic cell module according to a fifth embodiment of the present invention will be described with reference to FIGS. 7 to 9.

As illustrated, the photovoltaic cell module according to the fifth embodiment includes a plurality of unit modules 10, a connection unit 20 connecting the unit modules 10 to each other, and a fixing connector 30 fixing the unit modules by adjusting a folded angle between the unit modules.

Each of the unit modules 10 has a rectangular shape including a serial or parallel wiring 12 by electrically connecting a surface electrode and a ground electrode of the unit cell, which are adjacent to each other as the plurality of photovoltaic cell unit cells 11 are arranged.

The unit module 10 is manufactured according to a typical method in such a manner that tempered glass, a photovoltaic cell, a sealing material, and a back sheet are sequentially overlapped with each other, the sealing material is pressed and heated to bond and seal each layer, and then an edge of the tempered glass is fixed and finished by a metal material such as aluminum or a plastic reinforced frame. Thus, as the photovoltaic cells are arranged in a row within a thickness of about 7mm, the light weight photovoltaic cell unit module may be realized.

On the other hand, when a half cell is applied, since an internal current is reduced, and a cell gap is narrowed to reduce a resistance loss, a power output increases, and a temperature dependent performance is enhanced. Also, since an effect such as reduction in shadow effect of the output and decrease in possibility of hot spot generation is obtained, the rectangular unit module may have a length in a long distance greater by two times or more than that in a short distance by reflecting the effect.

Also, the unit module may be configured so that the number of cells disposed at one end in a minor direction is 1 to 6, and the number of cells disposed at one end in a major direction is 2 to 12, preferably, 1 to 2 in the minor direction, and 2 to 12 in the major direction.

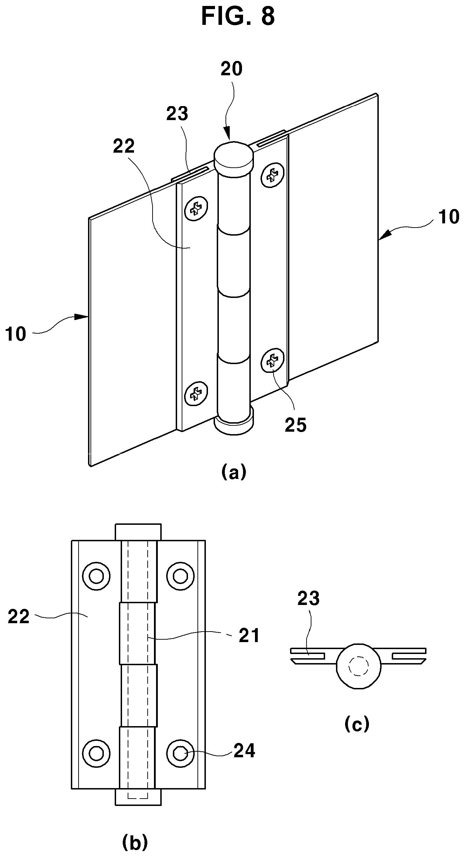

As illustrated in FIG. 8, the connection unit 20 includes a shaft 21 having a general cylindrical shape (including a bar or tube shape) and two hinge members 22 coupled in a rotatable manner. An insertion groove 23, to which one end of the unit module 10 is inserted and coupled, is defined in the other end, which is not coupled with the shaft 21, of the two hinge members 22. Also, a screw coupling hole 24 allowing a screw to be coupled is formed at each of upper and lower portions of a surface of the hinge member 22 in which the insertion groove 23 is formed. Thus, one end of the unit module 10 is inserted into the insertion groove 23, and then the unit module 10 is rotatably fixed to the shaft 21 by a bolt and nut 25 coupled through the screw coupling hole 24.

When the unit module 10 is coupled to only one side of the shaft 21, only one hinge member 22 may be formed. Also, one hinge member 22 may fix one unit module 10, or a plurality of hinge members 22 may fix one unit module 10.

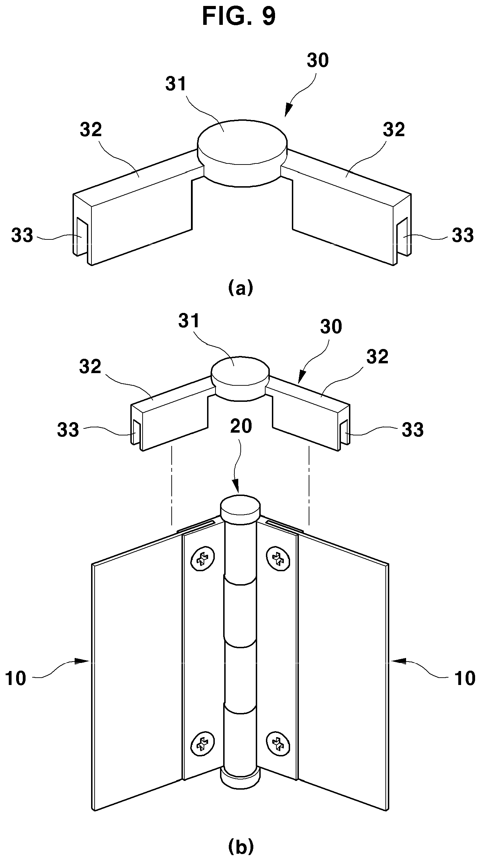

As illustrated in FIG. 9A, the fixing connector 30 includes a shaft fixing member 31 having a cylinder shape to be inserted to an upper end of the shaft 21 and having an inner diameter greater than an outer diameter of the shaft 21 and two module fixing members 32 connected to the shaft fixing member 31.

As a fixing groove 33 to which at least a portion of an upper end of the unit module 10 is inserted to be fixed is formed in the module fixing member 32, the upper end of the unit module 10 may be inserted to the fixing groove 33 so that the unit module 10 maintains a predetermined angle as illustrated in FIG. 9B.

The two module fixing members 32 in FIG. 9 are integrated with an outer circumferential portion of the shaft fixing member 32 at a preset angle (a fixed angle) in a non-rotatable manner.

As a folded angle between the unit modules 10 has a fixed angle in a range from 0° to 360°, a direction and a gap between the unit modules may be further firmly maintained. Preferably, as the fixed angle is in a range from 30° to 330°, an orientation angle between the unit modules may be in a range from 30° to 330°, and as the gap between the unit modules is equal to or less than a width of the unit module, more photovoltaic cells may be arranged in a narrow area.

In the fifth embodiment of the present invention, the folded angle between the unit modules is adjusted through an angle between the module fixing members integrated with the shaft fixing member 31.

### [Embodiment 6]

A sixth embodiment of the present invention includes a fixing connector capable of adjusting an angle between the unit modules 10 unlike the fifth embodiment.

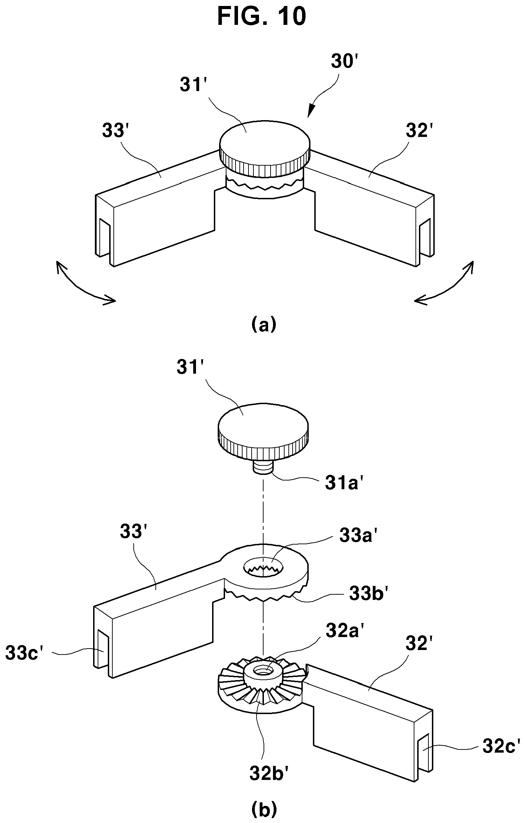

As illustrated in FIG. 10, a fixing connector 30' according to the sixth embodiment includes: a first member 31' in which a helix part 31a' is formed at a lower portion and a handle having a circular plate shape is formed at an upper portion; a second member 32' in which a hole 32a', in which a helix part is formed, is defined at a central portion, a plurality of catching grooves 32b' are formed at an outer circumferential portion, and a fixing groove 32c' extending a predetermined length so that an end of the unit module 10 coupled with the connection unit 20 is fixed at one side is defined at a lower side; and a third member 33' disposed between the first member 31' and the second member 32' and in which a coupling hole 33a', to which the protruding helix part 31a' is inserted, is defined at a central portion, a plurality of protruding parts 33b' caught by the catching groove 32b' of the second member 32' are formed at an outer circumferential portion, and a fixing groove 33c' extending a predetermined length so that the end of the unit module 10 coupled with the connection unit 20 is fixed at one side is defined at a lower side.

According to the sixth embodiment, an angle between the second member 32' and the third member 33' may be adjusted to adjust an angle between the unit modules 10 fixed thereto.

When angle adjustment is required by using the fixing connector according to the sixth embodiment, the angle adjustment may be performed such that the second member 32' and the third member 33' are separated from each other by rotating the first member 31', and then the second member 32' and the third member 33' are adjusted to required angles and assembled by using the first member 31'.

As described above, when the angles of the second member 32' and the third member 33' may be variously adjusted, a folded angle of the photovoltaic cell module may be adjusted according to an area of an installation space, and thus the space may be further effectively used, and a degree of freedom in installation may increase.

### [Embodiment 7]

A seventh embodiment of the present invention includes a fixing connector capable of automatically adjusting the angle between the unit modules 10 of the sixth embodiment without separating the fixing connector.

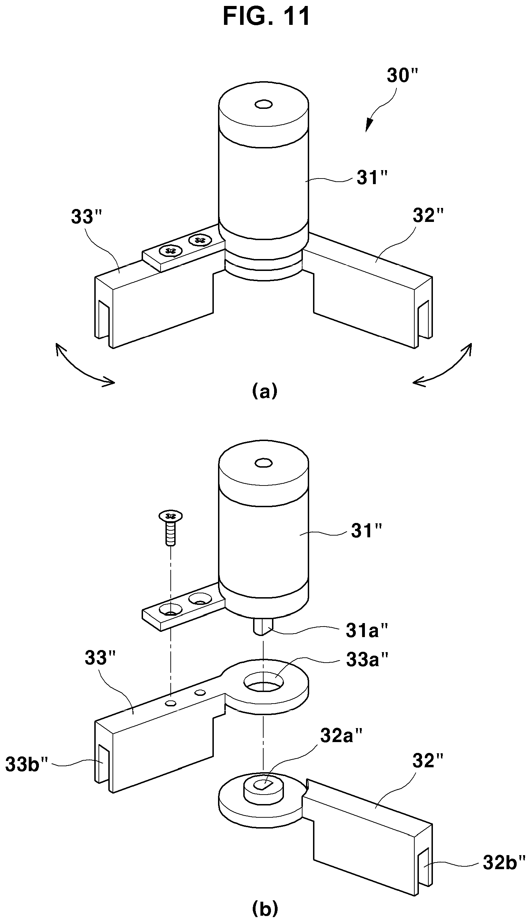

As illustrated in FIG. 11, a fixing connector 30" according to the seventh embodiment includes: a motor 31" including a rotation shaft 31a" having an angled cross-section of a predetermined shape at one end; a first fixing member 32" in which a coupling groove 32a" accommodating the angled cross-section of the rotation shaft 31a" is defined at a central portion, and a fixing groove 32b" extending a predetermined length so that the end of the unit module 10 coupled with the connection unit 20 is fixed at one side is defined at a lower side; and a second fixing member 33" disposed between the motor 31" and the first fixing member 32" and in which a coupling hole 33a", to which the rotation shaft 31a" is inserted, is defined at a central portion, and a fixing groove 33b" extending a predetermined length so that the end of the unit module 10 coupled with the connection unit 20 is fixed at one side of an outer circumferential portion is defined at a lower side.

When angle adjustment is required by using the fixing connector according to the seventh embodiment, the angle adjustment between the unit modules may be performed such that the motor 31" operates through a predetermined control signal to rotate the rotation shaft 31a", thereby adjusting an angle between the first fixing member 32" and the second fixing member 33".

Here, the motor 31" may be controlled in a wired or wireless manner by using a computer including a calculation device and a storage device. When the wireless control is necessary, the motor may include a receiving unit capable of receiving a control signal in a wireless manner.

Also, as the motor 31" operates by providing the control signal for each predetermined time on the basis of at least one information selected from a solar altitude, a sunrise time, and a sunset time according to a date stored in the storage device, an optimum folded state for the corresponding time may be obtained.

### [Embodiment 8]

An eighth embodiment of the present invention includes a support for installing the photovoltaic cell module of the embodiments 5 to 7.

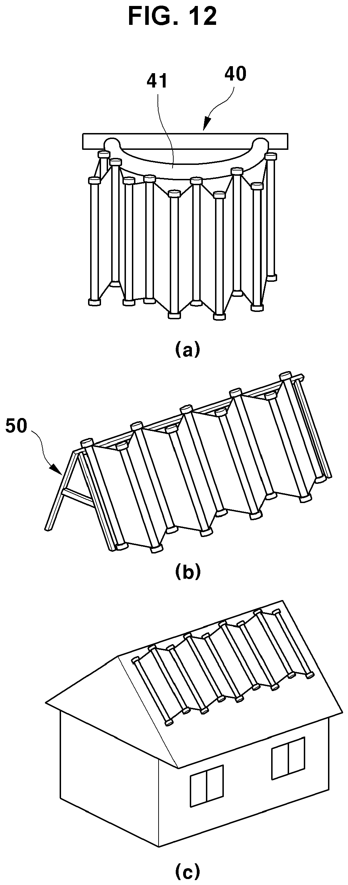

FIG. 12A is a view illustrating a state in which the photovoltaic cell module according to the present invention is fixed to a support 40 including a first support frame 41 having a curved part, a column supported by the ground or a wall surface, and a second support frame 41 supported by the column. The support 40 including the curved part in FIG. 12A has an advantageous structure allowing more photovoltaic cell modules to be disposed in a narrow area such as an apartment porch.

FIG. 12B is a view illustrating a state in which the photovoltaic cell module according to the present invention is fixed to a support 50 having a shape inclined at a predetermined angle with a cross-sectional shape of 'A'. This structure allows the photovoltaic cell module to be inclined at a predetermined angle in consideration of an incident angle of the sun.

FIG. 12C is a view illustrating a state in which the photovoltaic cell module according to the present invention is installed on an inclined roof. When the photovoltaic cell module may not be directly attached to the inclined roof, a support inclined at the same or similar angle may be installed on the roof, and then the photovoltaic cell module according to the present invention may be attached.

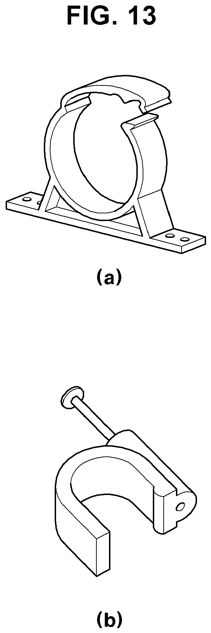

FIG. 13 is a view illustrating an example of a fixing device for fixing the photovoltaic cell module according to the present invention to a support. FIG. 13A illustrates a case that a fixing device is integrated with a frame coupled to a support through a screw, and FIG. 13B illustrates a case that a separated fixing device is directly coupled to a support through a screw.

When the fixing device is used, the photovoltaic cell module may be easily separated from the support, and as the connection unit is separated, the separated photovoltaic cell module may be separated into each unit module, and the each unit module may be stored and carried.

In the embodiment of the present invention, the fixing device may have the same or similar shape as that of the support assuming that the support has a cylinder or circular cylinder shape.

The photovoltaic cell module may be installed by connecting left and right sides of a plurality of unit modules to have a folding screen, thereby improving a space efficiency. Also, the solar radiation quantity and the power generation quantity improves through an effect of increasing the incident angle range of sunlight and the light receiving effective area more than the typical flat module. Also, since the photovoltaic cell module may be disassembled and separated into each unit module, storage, transferring, and maintenance are easily performed.

The international photovoltaic module prices and the power plant facility investment trend of the Korea Photovoltaic Industry Association shows that the ratio of the module cost in the entire photovoltaic power plant facility cost is reduced to 30% of that in the year of 2017. Thus, when the photovoltaic module is installed in the folding screen shape by extending the number of panels by two times in case that the photovoltaic module is installed in a flat shape in the same installation space of the photovoltaic panel (module), a total power plant facility cost may increase by 30% due to a panel cost, but a power generation output may increase by two times. Therefore, a photovoltaic equalization generation cost, i.e., a power generation unit cost, may improve by 54%. Thus, it may be known that the folding screen shape is economically advantageous than the flat shape.

Although the photovoltaic module having the folding screen shape is exemplified in the embodiment of the present invention, the embodiment of the present invention is not limited thereto. For example, the photovoltaic module may have various shapes instead of the flat shape.

### [Embodiment 9]

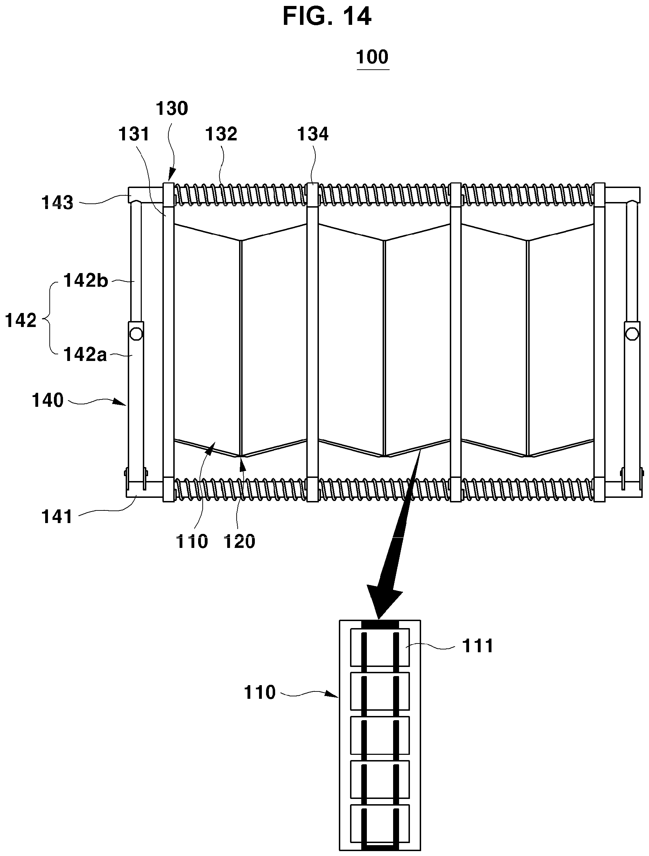

FIG. 14 is a perspective view illustrating a photovoltaic cell module according to a ninth embodiment of the present invention. As illustrated in FIG. 14, a photovoltaic cell module 100 according to the first embodiment of the present invention includes: a plurality of photovoltaic cell unit modules 110; a unit module connection unit 120 connecting the plurality of photovoltaic cell unit modules with neighboring unit modules in a bent manner; a unit module spacing unit 130 adjusting and fixing a distance between the plurality of photovoltaic cell unit modules and a curved angle when the plurality of unit modules are coupled and bent; and a holding unit 140 for holing the unit module spacing unit 130.

As illustrated in FIG. 14, a plurality of photovoltaic cell unit cells 111 are serial or parallel-connected to form one unit module 110, or a single photovoltaic cell may form one unit module. Although not particularly limited, the unit module 110 may generally have a rectangular shape.

The unit module connection unit 120 may physically connect and bent the neighboring unit modules 110 at the same time. For example, a mechanical rotating unit such as a hinge for mechanically connecting the plurality of photovoltaic cell unit modules in a bendable manner may be used. For another example, a method for connecting the unit modules 110 in a bendable manner by disposing a flexible member between both neighboring unit modules 110 and then attaching ends thereof by using a unit such as an adhesive, a bolt and a nut, and a Velcro may be used. Also, a wire for connecting electricity generated from the unit module 110 may be disposed in the unit module connection unit 120.

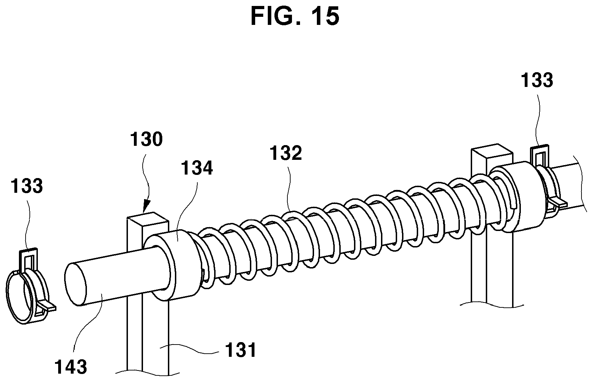

FIG. 15 is an enlarged perspective view illustrating the unit module spacing unit in FIG. 14.

As illustrated in FIGS. 14 and 15, the spacing unit 130 includes: a plurality of support bars 131; a spring 132 that is an elastic member for adjusting a gap between the plurality of support bars 131; and a clamp 133 capable of fixing the gap adjusted by the spring 132 and maintaining the gap.

A coupling part 134 in which a coupling hole for coupling the holding unit is formed is formed around both ends of each of the plurality of support bars 131. Also, the spring 132 is supported by the coupling part 134. Although the spring is used as the spacing member in the first embodiment of the present invention, a different type of an elastic member may be used in addition to the spring.

Also, two unit modules 110 are disposed in a space defined between the plurality of support bars 131, and an end of the unit module 110 adjacent to the support bar 131 is connected to the support bar 131 in a bendable manner. Although not particularly limited, the method for connecting the support bar 131 in the bendable manner may be referred to as a preferred example because the unit module 110 may be easily attached to and detached from the spacing unit 130 when an elastic band, a Velcro, or tongs are used.

For example, as illustrated in FIG. 15, the clamp 133 may be fixed and released by an elastic force. Although not particularly limited, a structure capable of being fixed and released by an elastic force of the spring 132 may be used.

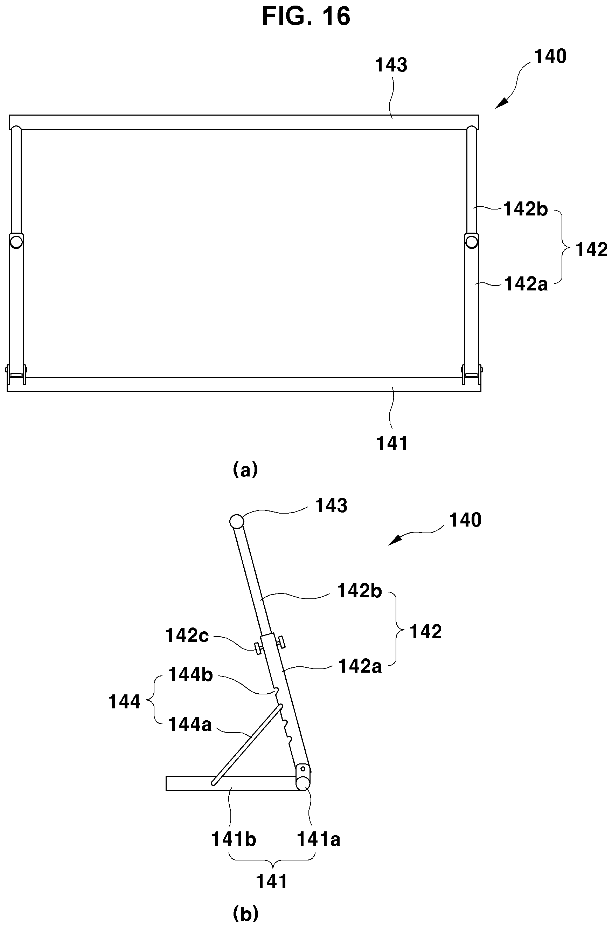

FIG. 16 is a front view and a side view illustrating a unit module holding unit of the photovoltaic cell module.

As illustrated, the holding unit 140 includes: a lower support 141 disposed at a lower portion; at least two inclined supports 142 rotatably connected to the lower support 141 so as to adjust an inclination and spaced a predetermined distance from each other; an upper support 143 connecting the at least two inclined supports 142 to each other; and an inclined angle adjusting unit 144 for adjusting an inclined angle by connecting the lower support 141 and the inclined support 142.

The lower support 141 includes: a first lower support 141a disposed parallel to the ground on the drawing; and two second lower supports 141b extending from both ends of the first lower support 141a in a direction perpendicular to the ground on the drawing.

The inclined support 142 includes: a first inclined support 142a including two hollow pipes and extending from the both ends of the first lower support 141a in a direction perpendicular to the first lower support 141a; a second inclined support 142b inserted into the first inclined support 142a; and a height adjusting unit 142c for adjusting a height of the second inclined support 142b. For example, the height adjusting unit 142c may include a hole defined in a predetermined portion of the first inclined support 142b and a screw inserted into the hole. However, the height adjusting unit 142c may include various well-known units.

The upper support 143 prevents the second inclined support 142b from moving and couples the spacing units 142 to each other. The upper support 143 having a pipe shape and couples ends of the spacing units 142 to each other. Although the upper support 143 is connected to both ends of the second inclined support 142b in the embodiment of the present invention, the connected position may be variously adjusted.

The inclined angle adjusting unit 144 includes: holes 144b spaced a predetermined gap along a longitudinal direction of the first inclined support 142a; and a support 144a rotatably connected to the second lower support 141b. Through this, an inclination may be adjusted according to a position of a hole into which the support 144a is inserted among the holes defined in the second lower support 141b. Although the inclination is adjusted by the method of inserting the support into the hole in the embodiment of the present invention, the inclination may be adjusted by various well-known methods, e.g., a hydraulic type support for adjusting a length of the support by a hydraulic pressure.

Next, a method for installing the photovoltaic cell module according to the ninth embodiment of the present invention will be described.

First, the support bar 131 is coupled to the holding unit 140 by inserting the lower support 141 and the upper support 142 of the holding unit 140 into the coupling parts 134 formed at both ends of the support bar 131 of the spacing unit 142, respectively. Here, the coil-type spring 132 is inserted between the support bars 131 to maintain a predetermined gap between the support bars 131.

Then, when a bent angle between the unit modules 110 is adjusted, the spring 132 is compressed by applying a force to the spring until a desired gap is obtained, and then the lower support 141 and the upper support 143 are fixed by using the clamp 134.

Thereafter, both side ends of each of two unit modules connected to the support bar 131 in a bendable manner are connected to the support bar 131. Here, since the unit modules are desirably connected to the support bar 131 in a bendable manner, the unit modules are connected to each other by using a unit such as an elastic bands, a Velcro, or tongs. The above-described unit may easily attach/detach the unit modules to/from the support bar 131 and conveniently store and transfer the unit modules.

Thereafter, an angle of the support 144a is adjusted in consideration of an incident angle of the sunlight.

As described above, the processes including attaching the unit module to the support bar 131 and adjusting the angle of the support may be performed before the support bar 131 is coupled to the holding unit 140, and an order of performing the processes is not particularly limited.

Also, in the spacing unit, the gap between the unit modules, i.e., the gap between the support bars, may be adjusted by using only a plurality of clamps without using the elastic member.

Also, when the photovoltaic cell module according to the first embodiment of the present invention is transferred or stored, the unit module, the spacing unit, and the holding unit may be disassembled in a reverse order of the above order.

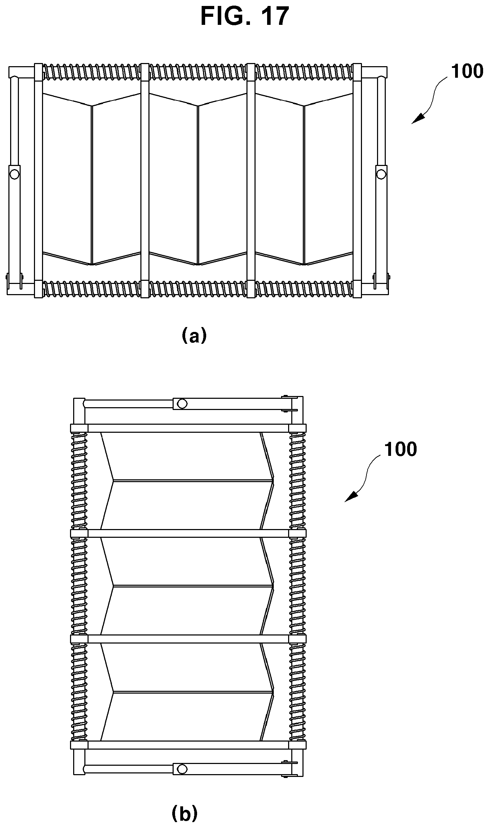

FIG. 17 is a view exemplarily illustrating a state in which the photovoltaic cell module according to the ninth embodiment of the present invention is installed. As illustrated in FIG. 17, the photovoltaic cell module according to the ninth embodiment of the present invention may be installed in a horizontal direction or in a vertical direction.

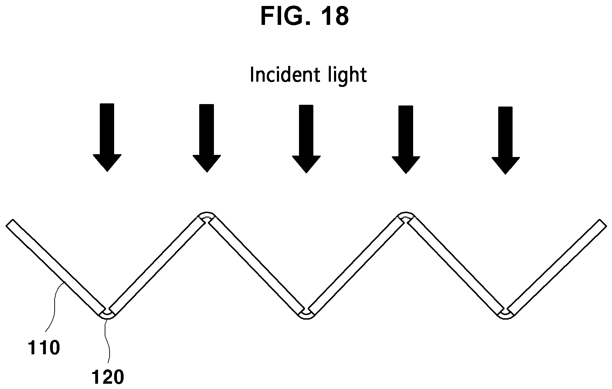

FIG. 18 is a view illustrating a state in which the photovoltaic cell module according to the present invention is installed with respect to incident light. As illustrated in FIG. 18, when the unit modules are arranged in a V-shape, a W-shape, or a repeated shape thereof with respect to an incident direction of sunlight, a portion of light reflected by one unit module may be re-absorbed to the unit module adjacent thereto to further improve a power generation efficiency.

Also, in case that the plurality of unit modules face each other as described above, by varying an internal angle between the unit modules between 180° and 0° when the incident light is vertically irradiated, while a horizontal installation area is reduced, a power generation amount is reduced by 30% or less with respect to an angle of 180° in an internal angle range from 120° to 40°. Thus, a feature of maintaining the internal angle range from 120° to 40° may be preferred.

When a unit module including a flexible thin-plate or thin-film photovoltaic cell is applied, the unit modules may be arranged in a U-shape or a repeated shape thereof to increase a power generation amount as similar to the above case.

Besides, when a double sided power generation photovoltaic cell is used for the above photovoltaic cell unit module having various bent shapes, since a power is generated from a front surface as well as a rear surface of the photovoltaic cell, the power generation amount may further improve.

### [Embodiment 10]

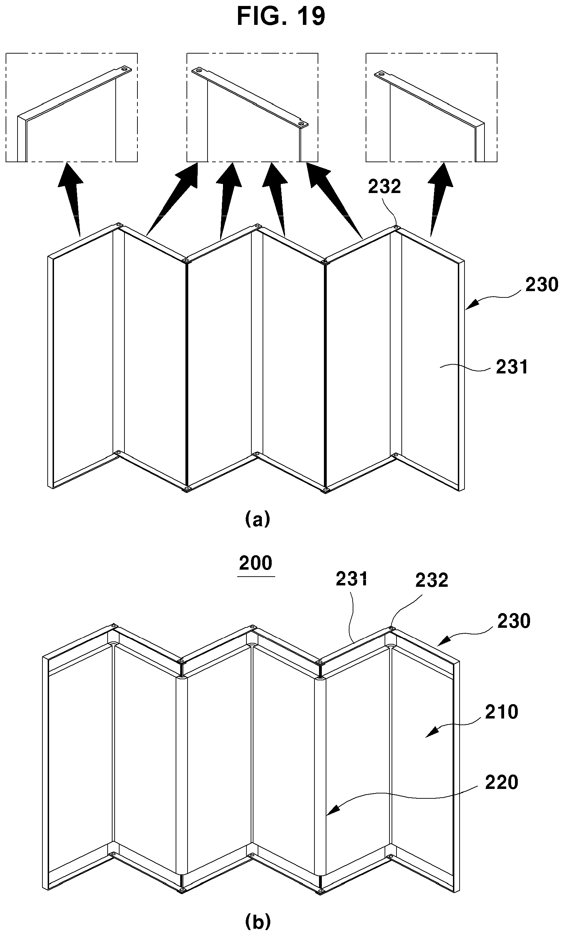

FIG. 19 is a view illustrating a photovoltaic cell module according to a tenth embodiment of the present invention, in which unit modules connected in a bendable manner are attached to each of surfaces of a support plate or a bent case.

As illustrated in FIG. 19, a photovoltaic cell module 200 according to the tenth embodiment includes: a plurality of photovoltaic cell unit modules 210; a unit module connection unit 220 for connecting the unit module to the adjacent unit module in a bendable manner among the plurality of photovoltaic cell unit modules; and a unit module spacing unit 230 capable of adjusting a bent gap between unit modules and to which the plurality of unit modules are attached.

The plurality of photovoltaic cell unit modules 210 and the unit module connection unit 220 may be the same as those in the ninth embodiment. Thus, redundant description will be omitted.

The spacing unit 230 includes a plurality of support plates 231 and a support plate connection unit 232 for rotatably connecting the plurality of support plates 231 to each other.

The support plate connection unit 232 has a hinge structure connecting both ends of the support plate 231 in a bendable manner.

Also, the unit modules may be attached to the support plate in various methods, e.g., a method of using a Velcro.

### [Embodiment 11]

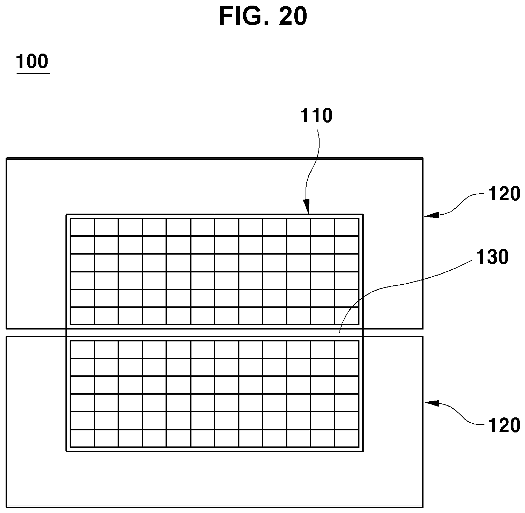

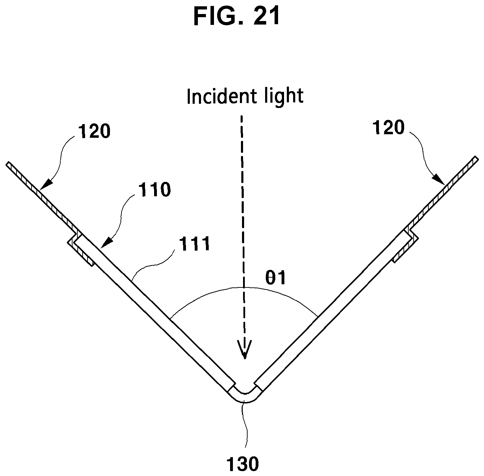

FIGS. 20 and 21 are a schematic view and a cross-sectional view illustrating a photovoltaic cell module according to eleventh embodiment of the present invention, respectively.

As illustrated in FIGS. 20 and 21, as two neighboring panels 110 are connected through a connection unit 130 in a state of being bent at a predetermined angle, the neighboring panels 110 are inclined to each other and face each other. The panel includes a reflection plate 120 extending from an edge thereof. The sunlight, which is not absorbed by the panel, may be reflected to the facing panel through the reflection plate to perform additional absorption, thereby improving a power generation efficiency.

An angle θ1 between the neighboring panels may be adjusted through the connection unit 130 in a range greater than 0° and less than 180°. The connection unit 130 may be bent while physically connecting the panels 110 at the same time. For example, a mechanical rotating unit such as a hinge for mechanically connecting in a bendable state may be used. For another example, a method for connecting the panels 110 in a bendable manner by disposing a flexible member such as plastic or fibers between both neighboring panels 110 and then attaching ends thereof by using a unit such as an adhesive, a bolt and a nut, and a Velcro. Also, a wire for connecting electricity generated from the panel 110 may be disposed in the connection unit 130.

When the panels are inclined and face each other as described above, a test for verifying increase in power generation of the photovoltaic cell is implemented. A table below shows results obtained by searching variation in power generation amount according to variation of an incident angle while irradiating vertical light with respect to a central portion of the panel and setting the internal angle θ1 between the panels to 60°.

**[Table 1]**

| | | | |
|---|---|---|---|
| Incident angle (°) of irradiating light | 0 | 15 | 30 |
| Increase rate (%) of power generation amount based on panel without reflection plate | 40.0 | 17.3 | 10.8 |

As shown in the above table 1, the power generation amount increases in comparison with a panel without the reflection plate with respect to various incident angles of irradiating light. The power generation amount gradually increases as a length of the reflection plate increases from an edge of the panel increases. However, the reflection plate may preferably have a transverse length of two times of a panel width and a longitudinal length of one times of a panel width in consideration of the gap between the panels so as to prevent a shadow caused by the reflection plate.

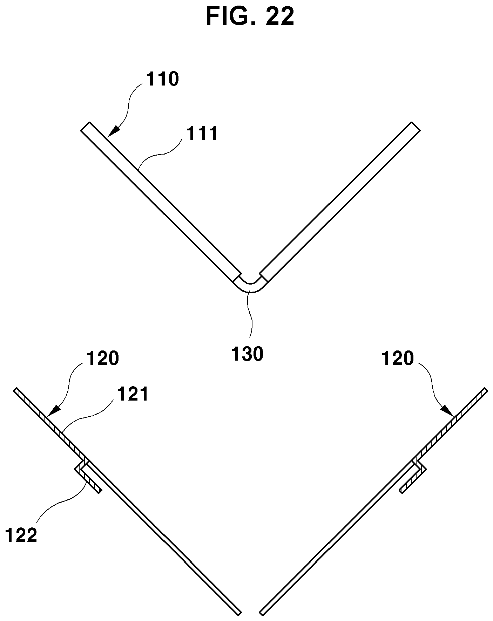

Also, the reflection plate extending from the panel may preferably extend without a stepped portion with the panel. When the stepped portion is formed, the power generation efficiency may be reduced, and foreign substances may be attached due to the stepped portion. In order to remove the stepped portion, as illustrated in FIG. 22, as a reflection surface 121 and an attachment surface 122 for being attached to the panel are connected with a difference as many as a panel thickness in the reflection plate, the attachment surface 122 may closely contact a rear surface of the panel and be attached thereto by using a bolt and a nut, a clamp, a screw, and a Velcro, and the reflection surface 121 may be connected to a surface 111 of the panel without the stepped portion (refer to FIG. 21).

The reflection surface 121, which is a surface of the reflection plate, may include a metal mirror surface, a glass mirror surface, or a plastic mirror surface to easily reflect the sunlight.

Also, the reflection plate may be manufactured by applying a reflecting material with a predetermined pattern on a substrate made of a transparent material such as acryl or glass. For example, a light reflecting material pattern may be formed on a transparent substrate by using a coating method such as deposition using vacuum deposition or screen printing. Besides, a method for attaching a metal foil on a transparent substrate may be applied. Here, since the substrate of the reflection plate has a thermal resistance, an insulating material capable of restricting temperature increase may be used.

The reflection plate may include a plurality of holes having various shapes. As the holes allows wind to pass therethrough, the wind may reduce a pressure applied to the panel and the reflection plate, and thus a damage risk of the photovoltaic cell module caused by strong wind may be also reduced.

### [Embodiment 12]

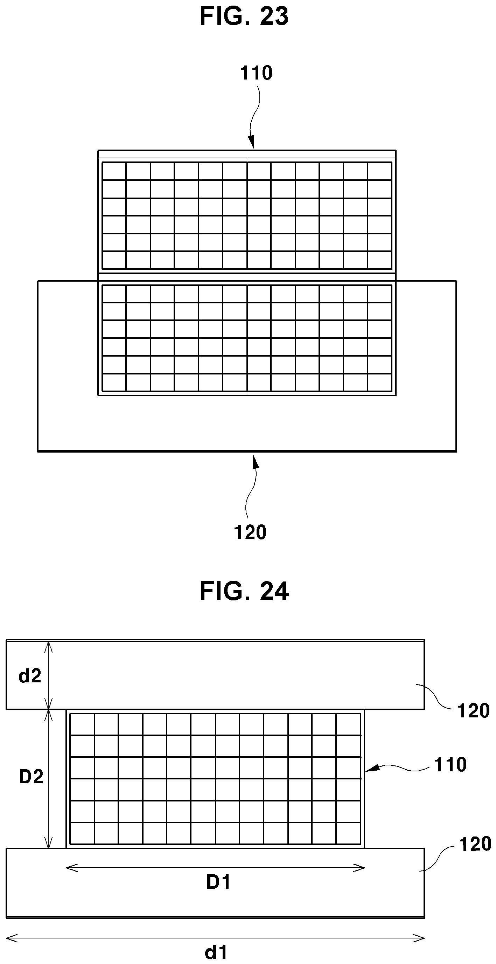

FIG. 23 is a view illustrating the same embodiment as the eleventh embodiment except that the reflection plate is contained in only one panel of the neighboring panels. When a plurality of photovoltaic cell modules are arranged, a shadow may be generated by the reflection plate, and the reflection panel may be disposed at only one side to prevent the shadow. Depending on cases, the reflection plate may be installed on only left and right sides or an upper portion of the panel.

### [Embodiment 13]

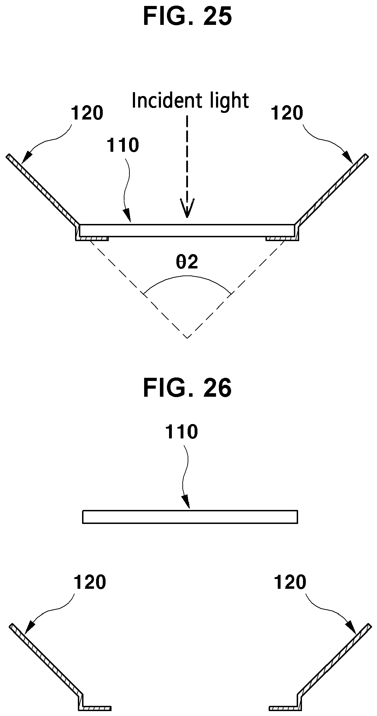

FIGS. 24 to 26 are schematic views for explaining a state in which a reflection plate is disposed at both ends in a vertical direction of a general flat panel. The reflection plate is disposed on each of a surface of the panel, which is close to the ground, and a surface opposite thereto (in the vertical direction) instead of surrounding all surfaces of the rectangular panel as illustrated in FIG. 25. At the same time, since the reflection plate has a width greater than that of the panel, the reflection plate protrudes in a side direction.

When the reflection plate is installed on all four surfaces of the flat panel, the sunlight may not reached to the panel due to a shadow. Also, as the reflection plate has a width greater than that of the panel, a frequency of the sunlight reflected and incident to the panel may increase to resultantly increase a sunlight power generation efficiency.

Dimensions of the reflection plate may have a width d1 and a length d2. The width d1 may be greater by one times and equal to less by three times than a transverse width D1 of the panel, and the length d2 may be equal to or less by one times than a longitudinal length D2 of the panel. More preferably, the width d1 may be greater by one times and equal to less by 1.5 times than the width D1, and the length d2 may be equal to or less by 0.5 times than the longitudinal length D2.

As described above, the reflection plate may have a width greater than that of the panel. When the reflection plate has a width greater by three times than that of the panel, an installation space may excessively increase, and an entire instability of the photovoltaic cell module may also increase due to increase in installation weight. Likewise, the length may be equal to or less by one times than the longitudinal length of the panel in terms of the installation space or the stability.

Also, the power generation efficiency of the photovoltaic cell may increase by adjusting an internal angle θ2 between the reflection plates 120 extending from the panels 110. A table 2 below shows an increase rate of the power generation amount according to the internal angle θ2 between the reflection plates 120 in a thirteenth embodiment of the present invention, representing that the power generation amount increases in a range from 40° to 120° and is maximized by 49.5% at an angle of 90°. Thus, the internal angle θ2 between the reflection plates 120 may be preferably in the range from 40° to 120°.

**[Table 2]**

| | | | | | | | | | |
|---|---|---|---|---|---|---|---|---|---|
| Internal angle (°) | 120 | 110 | 100 | 90 | 80 | 70 | 60 | 50 | 40 |
| Increase rate (%) of power generation amount | 3.8 | 16.9 | 44.6 | 49.5 | 35.1 | 20.1 | 40.0 | 42.5 | 25.4 |

### [Embodiment 14]

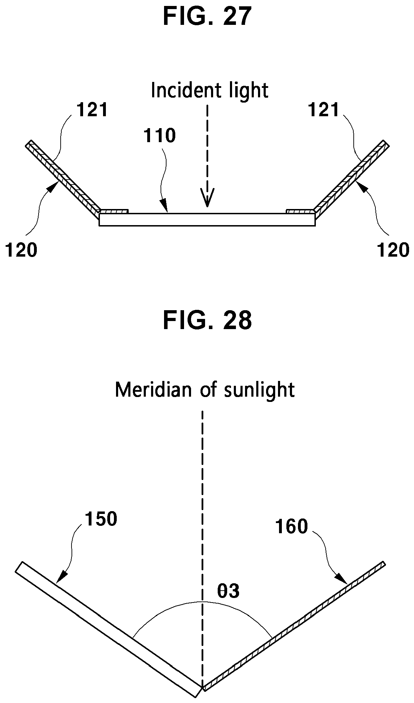

FIG. 27 is a view illustrating a state in which a reflection plate is disposed at each of both ends of a flat panel. Unlike the thirteenth embodiment, the reflection plate is connected to a front surface of the panel instead of a rear surface, and the reflection plate is manufactured by applying a reflection pattern on a transparent flat plate.

### [Embodiment 15]

FIG. 28 is a view illustrating a photovoltaic cell module in which a photovoltaic cell panel 150 and a reflection plate are inclined at a predetermined angle and face each other. In this case, two photovoltaic cell panels 150 may be provided instead of one panel.

More sunlight may be induced and absorbed to the panel by the reflection plate 160 inclined in a direction facing the panel. In FIG. 28, an internal angle θ3 between the panel 150 and the reflection plate facing the panel 150 is 120°. However, this angle may be varied.

### [Embodiment 16]

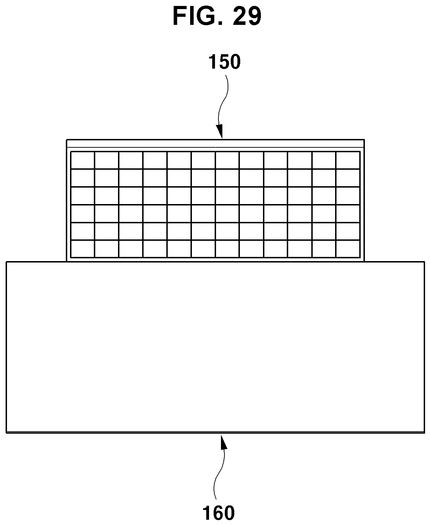

FIG. 29 is a view illustrating a photovoltaic cell module in which a photovoltaic cell panel 150 and a reflection plate 160 are inclined at a predetermined angle and face each other. The facing reflection plate may have an area greater by two times than that of the panel. This is different from a fifteenth embodiment in which the panel and the reflection plate have the same area as each other. As the area of the panel increases, a power generation amount increases.

Power generation increase rates according to the eleventh, fifteenth, and sixteenth embodiments are shown in a table below. In each embodiment, the power generation increase rate is measured by comparing with a case when panels are inclined and face each other (an internal angle of 60°) without the reflection plate under a condition in which the internal angle between the panel and the reflection plate is 60°, and an incident angle of irradiating light is 0°.

**[Table 3]**

| Embodiments | Increase rate (%) of power generation amount |
|---|---|
| Embodiment 11 | 40.0 |
| Embodiment 15 | 103.5 |
| Embodiment 16 | 129.1 |

### [Embodiment 17]

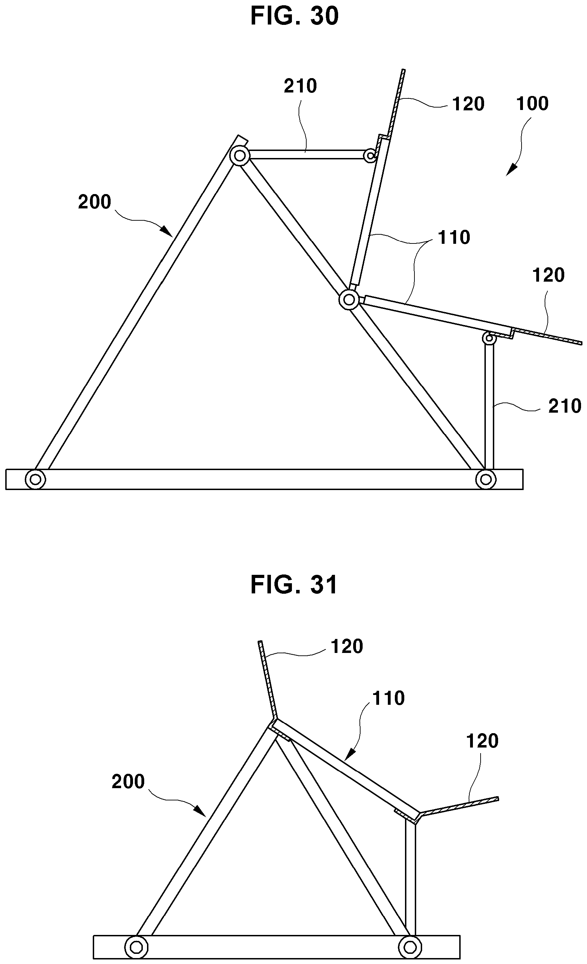

FIG. 30 is a view illustrating a state in which the photovoltaic cell module according to eleventh embodiment is attached to a holder.

A photovoltaic cell module 100 may be stably maintained as a support 210 holes at a plurality of points including a reflection plate. The support 210 may be detached and attached as necessary, and thus this embodiment may be advantageous in terms of maintenance.

The support 210 and the holder 200 may be attached to each other through coupling using a bolt and a nut, insertion using a concave and a convex, fixing using a clamp, and attaching using an adhesive.

### [Embodiment 18]

FIG. 31 is a view illustrating a state in which the photovoltaic cell module according to thirteenth embodiment is attached to a holder.

## Claims

1. A photovoltaic cell module comprising at least two unit modules,
wherein each of the unit modules comprises at least one photovoltaic cell comprising a light absorbing layer and an electrode, and
a power generation is performed in a state in which an own shape of the unit module or an arranged shape of two or more unit modules forms an uneven portion on an incident surface to which the sunlight is incident.

2. The photovoltaic cell module of claim 1, further comprising a support unit on which the unit module is installed,
wherein the support unit comprises at least one post fixed to the ground or a structure, a support fixed to the post, and a holder configured to form an uneven shape on the support,
the unit module comprises a plate shape, and
at least two unit modules are installed on the holder to form an uneven portion on an incident surface to which the sunlight is incident.

3. The photovoltaic cell module of claim 2, wherein each of the at least two unit modules has a rectangular shape in which a length in one direction is greater by two times than a length in the other direction.

4. The photovoltaic cell module of claim 2, wherein the holder has a shape of a rod extending in a longitudinal direction, and the rod has a cross-section having a polygonal shape, a semi-circular shape, or a semi-elliptical shape.

5. The photovoltaic cell module of claim 1, wherein the unit module comprises a flexible photovoltaic cell, and
the flexible photovoltaic cell is molded to form an uneven portion on an incident surface to which the sunlight is incident.

6. The photovoltaic cell module of claim 1, wherein the unit modules are arranged with different orientations to be adjusted in height and direction.

7. The photovoltaic cell module of claim 1, wherein the unit module comprises at least two kinds having different protruding shapes and/or different heights.

8. The photovoltaic cell module of claim 2, wherein the support unit has a curved shape having a predetermined radius, and
the at least two unit modules form a shape protruding to be curved with a predetermined shape toward a surface on the support unit, and the uneven shape overlaps the curved shape of the support unit.

9. The photovoltaic cell module of claim 2, wherein the unit module is installed to form an uneven portion comprising an embossing shape on the support unit.

10. The photovoltaic cell module of claim 1, wherein the unit module comprises a plurality of uneven portions comprising an embossing shape.

11. A photovoltaic cell module comprising at least two unit modules,
wherein each of the unit modules comprises at least one photovoltaic cell comprising a light absorbing layer and an electrode,
a connection unit configured to connect the at least two unit modules is disposed between the at least two unit modules,
the connection unit allows the unit modules to be folded and simultaneously adjusts and fixes a folded angle, and
a power generation is performed in a state in which the at least two unit modules face each other at a predetermined angle by the connection unit to form an uneven portion on an incident surface to which the sunlight is incident.

12. The photovoltaic cell module of claim 11, wherein a facing angle of the unit modules is in a range from 30° to 330°, and a gap between the unit modules is equal to or less than a width of the unit module.

13. The photovoltaic cell module of claim 11, wherein the connection unit comprises a shaft, a connection member rotatably connected to the shaft, and a fixing connector coupled with one side of the connection member configured to connect neighboring unit modules to adjust and fix a folded angle between the unit modules, and
as one side or both sides of each of the unit modules is or are connected to the connection member, the unit module is rotatably connected to the shaft.

14. The photovoltaic cell module of claim 13, wherein the fixing connector comprises a body, a first fixing member connected to the body and fixed to one end of the unit module, and a second fixing member fixed to one end of the unit module adjacent and connected to the unit module fixed to the first fixing member, and
the folded angle between the unit modules is adjusted by adjusting an angle between the first fixing member and the second fixing member.

15. The photovoltaic cell module of claim 13, wherein the fixing connector comprises a body, a first fixing member connected to the body and fixed to one end of the unit module, and a second fixing member fixed to one end of the unit module adjacent and connected to the unit module fixed to the first fixing member,
one side or both sides of each of the first fixing member and the second fixing member is or are rotatably connected to the body, and
as an angle adjusting unit configured to fix the first fixing member or the second fixing member, which is rotatably connected, is provided, an angle between the first fixing member or the second fixing member is adjusted through the first fixing member, the second fixing member, and the angle adjusting unit.

16. The photovoltaic cell module of claim 13, wherein the fixing connector comprises a driving unit, a first fixing member fixed to one end of the unit module, and a second fixing member fixed to one end of the unit module adjacent and connected to the unit module fixed to the first fixing member, and
the driving unit rotates one side or both sides of each of the first fixing member and the second fixing member to adjust an angle between the first fixing member and the second fixing member.

17. The photovoltaic cell module of claim 11, further comprising:
a support configured to support at least one of the at least two unit modules; and
a fixing unit configured to fix the unit module on the support.

18. The photovoltaic cell module of claim 11, wherein the at least two unit modules are separated from or coupled to each other.

19. A photovoltaic cell module comprising at least two unit modules,
wherein each of the unit modules comprises at least one photovoltaic cell comprising a light absorbing layer and an electrode, and
a power generation is performed in a state an uneven portion is formed on an incident surface to which the sunlight is incident by comprising:
a unit module connection unit configured to connect the at least two unit modules with neighboring unit module in a bendable manner; and
a unit module spacing unit coupled to the unit module and configured to adjust and fix a bent angle and a distance between the plurality of unit modules when the unit modules are bent.

20. The photovoltaic cell module of claim 19, further comprising a holding unit configured to hold the unit module spacing unit.

21. The photovoltaic cell module of claim 19, wherein the spacing unit comprises:
a plurality of support bars spaced a predetermined distance from each other;
at least one spacing member configured to adjust a gap between the plurality of support bars; and
at least one fixing member configured to maintain the gap adjusted by the at least one spacing member,
wherein the unit module is coupled to the plurality of support bars in a bendable manner.

22. The photovoltaic cell module of claim 20, wherein the holding unit comprises:
a lower support disposed at a lower portion;
at least two inclined supports rotatably connected to adjust an inclination with respect to the lower support and spaced a predetermined distance from each other;
an upper support configured to connect the at least two inclined supports to each other; and
an inclined angle adjusting unit configured to adjust an inclined angle by connecting the lower support and the inclined support.

23. The photovoltaic cell module of claim 19, wherein the unit module is connected to the spacing unit by an elastic band, a Velcro, or tongs.

24. The photovoltaic cell module of claim 19, wherein a bent angle between the unit module and neighboring unit module is in a range from 0° to 360°, and a gap between the unit modules is equal to or less than two times of a width of the unit module.

25. The photovoltaic cell module of claim 19, wherein the unit module comprises a single cell or a plurality of cells that are serial or parallel-connected to each other.

26. The photovoltaic cell module of claim 21, wherein the spacing member is a spring, and the fixing member is a clamp disposed at each of both ends of the spring.

27. The photovoltaic cell module of claim 22, wherein a length of the inclined support is adjustable.

28. The photovoltaic cell module of claim 19, wherein the unit module spacing unit comprises:
a plurality of support plates; and
a connection unit configured to connect the plurality of support plates in a rotatable manner so that the plurality of support plates are folded with each other,
wherein the plurality of photovoltaic cell unit modules are attached to the plurality of support plates, respectively.

29. The photovoltaic cell module of claim 19, wherein the unit module connection unit comprises a mechanical rotating unit configured to connect the plurality of photovoltaic cell unit module in a mechanically bendable manner or a member having a flexibility to be bent by a material property without a separate mechanical unit.

30. A photovoltaic cell module comprising at least two unit modules,
wherein each of the unit modules comprises at least one photovoltaic cell comprising a light absorbing layer and an electrode, and
a power generation is performed in a state in which the at least two unit modules are arranged to form uneven portions facing each other on an incident surface to which the sunlight is incident.

31. The photovoltaic cell module of claim 30, wherein the neighboring unit modules are arranged to have a V-shape, a W-shape, or a repeated shape thereof.

32. The photovoltaic cell module of claim 30, wherein the neighboring unit modules are arranged to have a U-shape or a repeated shape thereof with respect to incident light.

33. The photovoltaic cell module of claim 30, wherein an internal angle between the neighboring unit modules is in a range from 120° to 40°.

34. A photovoltaic cell module comprising at least two unit modules and a reflection plate,
wherein each of the unit modules comprises at least one photovoltaic cell comprising a light absorbing layer and an electrode, and
as the at least two unit modules are arranged to form uneven portions facing each other with a predetermined angle on an incident surface to which the sunlight is incident, and the reflection plate is connected to at least a portion of an end of the photovoltaic cell panel and extends a predetermined length, a power generation is performed in a state in which the uneven portions are formed on the incident surface to which the sunlight is incident.

35. The photovoltaic cell module of claim 34, wherein the predetermined angle is adjustable in a range greater than 0° and less than 180°.

36. The photovoltaic cell module of claim 34, wherein a surface of the reflection plate extends without a stepped portion with a surface of the photovoltaic cell panel.

37. The photovoltaic cell module of claim 34, wherein the reflection plate extends from all of opened ends of the photovoltaic cell panel.

38. A photovoltaic cell module comprising a unit module and reflection plates,
wherein the unit module comprises at least one photovoltaic cell comprising a light absorbing layer and an electrode,
the reflection plates comprise a first reflection plate connected to one end of the unit module and inclined at a predetermined angle with respect to an incident surface of the sunlight of the unit module and a second reflection plate connected to the other end, which is disposed at the opposite side of the unit module and inclined at a predetermined angle with respect to an incident surface of the sunlight of the photovoltaic cell panel, and
as the first reflection plate and the second reflection plate are arranged to face each other, a power generation is performed in a state in which an uneven portion is formed on the incident surface to which the sunlight is incident.

39. The photovoltaic cell module of claim 38, wherein an internal angle between the first reflection plate and the second reflection plate, which face each other, is in a range from 40° to 120°.

40. The photovoltaic cell module of claim 38, wherein each of the first reflection plate and the second reflection plate has a width greater by one times and equal to or less than three times of a transverse width of the photovoltaic cell panel and a length equal to or less by one times than a longitudinal length of the photovoltaic cell panel.

41. A photovoltaic cell module comprising a unit module and a reflection plate,
wherein the unit module comprises at least one photovoltaic cell comprising a light absorbing layer and an electrode, and
as the reflection plate is inclined at a predetermined angle with respect to the unit module to face each other, a power generation is performed in a state in which an uneven portion is formed on the incident surface to which the sunlight is incident.

42. The photovoltaic cell module of claim 41, wherein the reflection plate is inclined at a predetermined angle with respect to at least two unit photovoltaic cell panels.

43. The photovoltaic cell module of claim 41 or 42, wherein the predetermined angle is in a range from 40° to 120°.

44. The photovoltaic cell module of any one of claims 34, 38, and 41, wherein the reflection plate has an area equal to or greater by one times than the photovoltaic cell panel.

45. The photovoltaic cell module of any one of claims 34, 38, and 41, wherein a surface of the reflection plate comprises a metal mirror surface, a glass mirror surface, or a plastic mirror surface.

46. The photovoltaic cell module of any one of claims 34, 38, and 41, wherein the reflection plate comprises a transparent substrate and a light reflecting material attached on the transparent substrate.

47. The photovoltaic cell module of any one of claims 34, 38, and 41, wherein a substrate of the reflection plate comprises an insulating material.

48. The photovoltaic cell module of any one of claims 34, 38, and 41, wherein the reflection plate comprises at least one hole through which wind passes.

49. The photovoltaic cell module of claim 48, wherein a shape of the hole is selected from the group consisting of a circular shape, a triangular shape, a rectangular shape, a polygonal shape, a cross shape, and an arbitrary shape.

50. The photovoltaic cell module of any one of claims 34, 38, and 41, wherein a thermoelectric element is attached to the unit module or the reflection plate.

51. The photovoltaic cell module of any one of claims 34, 38, and 41, wherein a phase change material is attached to the unit module or the reflection plate.

52. The photovoltaic cell module of any one of claims 34, 38, and 41, further comprising a holder configured to hold the unit module and the reflection plate and adjust a facing angle between the unit modules or between the unit module and the reflection plate.
